# FASCICULE DE BREVET EUROPEEN

(11) **EP 1 520 327 B1**
(45) Date de publication et mention de la délivrance du brevet: **22.09.2010**
(21) Numéro de dépôt: 03763926.7
(22) Date de dépôt: 04.07.2003
(51) Int. Cl.: H01S 5/10

(54) **LASER DFB A REFLECTEUR DISTRIBUE A BANDE PHOTONIQUE INTERDITE**
DFB LASER MIT PHOTONISCHER BANDLÜCKE UND VERTEILTEM REFLEKTOR
DFB LASER WITH A DISTRIBUTED REFLECTOR AND PHOTONIC BAND GAP

(30) Priorité: 08.07.2002 FR 0208543
(43) Date de publication de la demande: 06.04.2005
(73) Titulaire: Oclaro (North America), Inc., Fremont, CA 94538 (US)
(72) Inventeur: THEDREZ, Bruno, F-75014 Paris (FR)
(74) Mandataire: Feray, Valérie
(86) Numéro de dépôt international: PCT/FR2003/002063
(87) Numéro de publication internationale: WO 2004/008591

(56) Documents cités:
- EP-A- 0 468 482
- US-A- 5 684 817
- HAPP T D ET AL: "RIDGE WAVEGUIDE LASERS WITH 2D PHOTONIC CRYSTAL MIRRORS" COMPOUND SEMICONDUCTORS 1999. PROCEEDINGS OF THE 26TH INTERNATIONAL SYMPOSIUM ON COMPOUND SEMICONDUCTORS. BERLIN, AUG. 22 - 26, 1999, INSTITUTE OF PHYSICS CONFERENCE SERIES, LONDON: IOP, GB, vol. NR. 166, 22 août 1999 (1999-08-22), pages 411-414, XP000921543 ISBN: 0-7503-0704-8
- VURGAFTMAN I ET AL: "PHOTONIC-CRYSTAL DISTRIBUTED-FEEDBACK LASERS" APPLIED PHYSICS LETTERS, AMERICAN INSTITUTE OF PHYSICS. NEW YORK, US, vol. 78, no. 11, 12 mars 2001 (2001-03-12), pages 1475-1477, XP001015018 ISSN: 0003-6951
- KAMP M ET AL: "Lateral coupling - a material independent way to complex coupled DFB lasers" OPTICAL MATERIALS, ELSEVIER SCIENCE PUBLISHERS B.V. AMSTERDAM, NL, vol. 17, no. 1-2, juin 2001 (2001-06), pages 19-25, XP004254783 ISSN: 0925-3467
- PATENT ABSTRACTS OF JAPAN vol. 011, no. 059 (E-482), 24 février 1987 (1987-02-24) & JP 61 218191 A (HITACHI LTD), 27 septembre 1986 (1986-09-27)

## Description

L'invention concerne le domaine des dispositifs optiques, et plus particulièrement celui des lasers à semi-conducteurs de type DFB (Distributed FeedBack).

Comme le sait l'homme de l'art, les lasers DFB, comme par exemple ceux dits « à ruban enterré », comprennent généralement un guide d'onde actif, comportant classiquement une région active, enterré dans un matériau de rebouchage, et couplé à des structures formant un réseau de diffraction (ou réflecteur distribué) grâce à une variation périodique d'indice. En termes de structure guidante, la région active est assimilable au coeur du guide tandis que le matériau de rebouchage qui l'entoure, à plus faible indice, correspond à sa gaine.

Le réflecteur distribué apportant une modification périodique de l'indice de réfraction, seuls des photons émis par la région active et présentant une longueur d'onde imposée par le réflecteur contribuent à l'oscillation laser. Par conséquent, un laser DFB présente, en théorie, une empreinte spectrale étroite qui en fait un laser monomode.

Mais, dans la pratique, tel n'est pas exactement le cas du fait de la complexité des procédés utilisés actuellement pour fabriquer les réflecteurs distribués. Il faut en effet que les réflexions au niveau des extrémités du laser (typiquement des facettes opposées du composant) soient en phase avec les réflexions induites par le réseau du réflecteur distribué. Ces conditions de phase ne peuvent être obtenues qu'en positionnant la facette du laser de manière très particulière par rapport au réseau de diffraction, et ceci avec une précision très inférieure à la longueur d'onde.

Par ailleurs, ce mode de fabrication des réflecteurs distribués ne permet que difficilement de faire varier la force du réseau (en anglais "grating strength"), c'est à dire le coefficient de couplage entre l'onde optique et le réseau, d'un laser à l'autre sur une même plaquette (en anglais « wafer »). De même, il est difficile de faire varier avec précision la force du réseau le long de l'axe longitudinal du laser.

Des solutions ont été proposées pour tenter de remédier à ces inconvénients. Une solution consiste simplement à dédier une plaquette à chaque type de réflecteur distribué. Mais, cette solution est onéreuse. Une autre solution consiste à désorienter le réseau pour réduire sa force de réseau. Mais, cette solution change la longueur d'onde de Bragg du réseau, et peut en outre diffracter des photons dans des directions indésirables. Elle ne permet pas non plus de faire varier la force du réseau le long de l'axe longitudinal du laser DFB.

L'invention a donc pour but de remédier à tout ou partie des inconvénients précités.

Elle propose à cet effet un laser semi-conducteur, du type présenté dans l'introduction et selon lequel le réflecteur distribué est réalisé dans le matériau de rebouchage qui entoure la région active du guide d'onde actif, le long d'au moins un de ses côtés latéraux (de préférence les deux), et sensiblement parallèlement à ceux-ci, sous la forme d'au moins une première structuration présentant une bande photonique interdite selon l'axe longitudinal du laser.

Classiquement, on considère qu'une structure laser s'étend selon trois directions perpendiculaires entre elles, une direction dite « longitudinale » (X), définissant l'axe longitudinal du laser par rapport à laquelle on définit son extension longitudinale L (ou longueur), une direction dite « latérale » (Y), par rapport à laquelle on définit par exemple l'extension latérale I (ou largeur) de la région active du guide d'onde, et une direction dite « verticale » (Z), selon la direction d'empilement des couches et par rapport à laquelle on définit par exemple l'extension verticale h (ou hauteur) de la région active du guide d'onde. Par conséquent, l'expression « le réflecteur distribué est réalisé le long d'au moins un des côtés latéraux de la région active » signifie que le réflecteur s'étend sur toute la longueur L de la région active du laser, ou sur une partie de celle-ci, sensiblement parallèlement à un plan défini par les directions verticale (Z) et longitudinale (X). Les expressions "extension longitudinale", "extension latérale" et "extension verticale" sont utilisées de préférence aux termes plus communs "longueur", "largeur" et "hauteur" respectivement car ils visent à désigner des caractéristiques géométriques de structures et non pas de simples dimensions.

Par ailleurs, on entend ici par « structuration à bande photonique interdite » un réseau n-dimensionnel (n étant de préférence égal à 2, mais pouvant également être égal à 1 ou à 3) dont les propriétés physiques offrent un contrôle de la propagation de la lumière, en l'interdisant pour certaines longueurs d'onde dans certaines directions de l'espace.

Le réflecteur distribué selon l'invention sert donc à filtrer dans la direction longitudinal certaines longueurs d'onde et non pas à assurer un confinement latéral et vertical, lequel est assuré par la constitution même de la région active enterrée. Cela permet notamment de fixer la force du réseau à toute valeur voulue en jouant principalement sur la distance séparant le réseau de la couche active.

La première structuration s'étend préférentiellement sur la totalité de l'extension latérale (ou largeur) du matériau de rebouchage placé de part et d'autre des côtés latéraux de la région active. Mais, elle pourrait également s'étendre sur une partie seulement de cette extension latérale.

En outre, la première structuration s'étend sur une partie au moins de l'extension de la région active suivant la direction verticale, préférentiellement sur sa totalité, et sur une partie ou la totalité de la hauteur du matériau de rebouchage.

Dans un mode de réalisation préféré, la première structuration est un premier cristal photonique formé par gravure localisée du matériau de rebouchage de façon à y former des colonnes creuses ou à y laisser subsister des colonnes de matériau, ces colonnes constituant un réseau périodique d'éléments diffractants présentant dans un plan horizontal une maille ayant des dimensions de l'ordre de la longueur d'onde de fonctionnement du laser. Plus préférentiellement encore, les colonnes s'étendent sensiblement parallèlement à la direction d'empilement des couches.

Par ailleurs, la maille de réseau du premier cristal photonique a préférentiellement une forme de polygone convexe, et dont la taille est choisie en fonction de la longueur d'onde de fonctionnement recherchée. Ce polygone convexe est de préférence un polygone régulier (c'est-à-dire dont tous les côtes sont égaux), tel qu'un carré, un triangle équilatéral ou un losange.

La première structuration est espacée de la région active d'une distance choisie en fonction de la force du réseau requise pour le réflecteur distribué, de sorte que soient extraits les photons qui présentent une longueur d'onde différente de celle des photons dans le mode recherché.

Selon une autre caractéristique de l'invention, cette distance peut être soit constante, soit variable le long de l'extension longitudinale (ou longueur) L de la région active de manière à faire varier longitudinalement la force du réseau. L'intérêt de cette dernière disposition est qu'elle permet de réaliser des lasers à sélectivité spectrale améliorée, par exemple en contrôlant la distribution longitudinale de la densité de puissance dans la structure laser.

Selon encore une autre caractéristique de l'invention, le matériau de rebouchage du guide d'onde actif peut être également prévu à l'une au moins des extrémités longitudinales de la région active, de manière à recevoir, à une distance δL des extrémités longitudinales de la première structuration, des moyens de réflexion réalisés sous la forme d'une seconde structuration à bande photonique interdite et s'étendant sensiblement parallèlement à l'extension latérale de la région active. Cette seconde structuration sert de miroir arrière pour le laser DFB. Par ailleurs, la distance δL peut être choisie sensiblement égale à un nombre entier de fois la demie longueur d'onde des photons dans le mode guidé (c'est-à-dire la demie longueur d'onde de fonctionnement du laser dans le matériau de rebouchage), de sorte que les première et seconde structurations définissent une cavité résonnante de type Fabry-Pérot.

Préférentiellement, cette seconde structuration s'étend sur la totalité de l'extension latérale (ou largeur) du guide d'onde. Mais, elle pourrait s'étendre sur la largeur de la région active et tout ou partie de l'extension latérale du matériau de rebouchage placé de part et d'autre des côtés latéraux de la région active (dans les zones où est formée la première structuration). De même, elle s'étend de préférence sur toute la hauteur (direction d'empilement) de la région active, et plus préférentiellement encore sur toute la hauteur du matériau de rebouchage qui entoure notamment la région active.

Egalement de préférence, la seconde structuration est un second cristal photonique formé par gravure localisée du matériau de rebouchage de façon à y former des colonnes creuses ou à y laisser subsister des colonnes de matériau, ces colonnes constituant un réseau périodique d'éléments diffractants présentant dans un plan horizontal une maille ayant des dimensions de l'ordre de la longueur d'onde de fonctionnement du laser.

Dans ce cas, il est préférable que les colonnes s'étendent sensiblement parallèlement à l'extension verticale (ou hauteur h) de la région active, sur tout ou partie (région active au moins) du guide d'onde. Il est également avantageux que la maille de réseau du second cristal photonique ait une forme de polygone convexe, de préférence d'un polygone régulier.

Avantageusement, les polygones convexes des premier et second cristaux photoniques sont associés à des longueurs d'onde de Bragg sensiblement identiques. Par ailleurs, dans un mode de réalisation préférentiel les premier et second cristaux photoniques sont constitués de polygones convexes de types différents.

D'autres caractéristiques et avantages de l'invention apparaîtront à l'examen de la description détaillée ci-après, et des dessins annexés, sur lesquels :
- la figure 1 est une vue en coupe transversale schématique, dans le plan (YZ), d'un laser DFB selon l'invention, équipé d'un premier type de cristal photonique,
- la figure 2 est une vue en coupe transversale, selon l'axe A de la figure 1 (dans le plan (XY)),
- la figure 3 est une vue en coupe identique à celle de la figure 2, mais illustrant un laser DFB équipé d'un second type de cristal photonique,
- la figure 4 est une vue en coupe identique à celle de la figure 2, mais illustrant un autre laser DFB selon l'invention, équipé d'un premier cristal photonique définissant le réflecteur distribué, et d'un second cristal photonique, définissant un réflecteur arrière.

Les dimensions des différents éléments constituant les lasers DFB illustrés sur les figures ne sont pas représentatives de leurs dimensions réelles respectives.

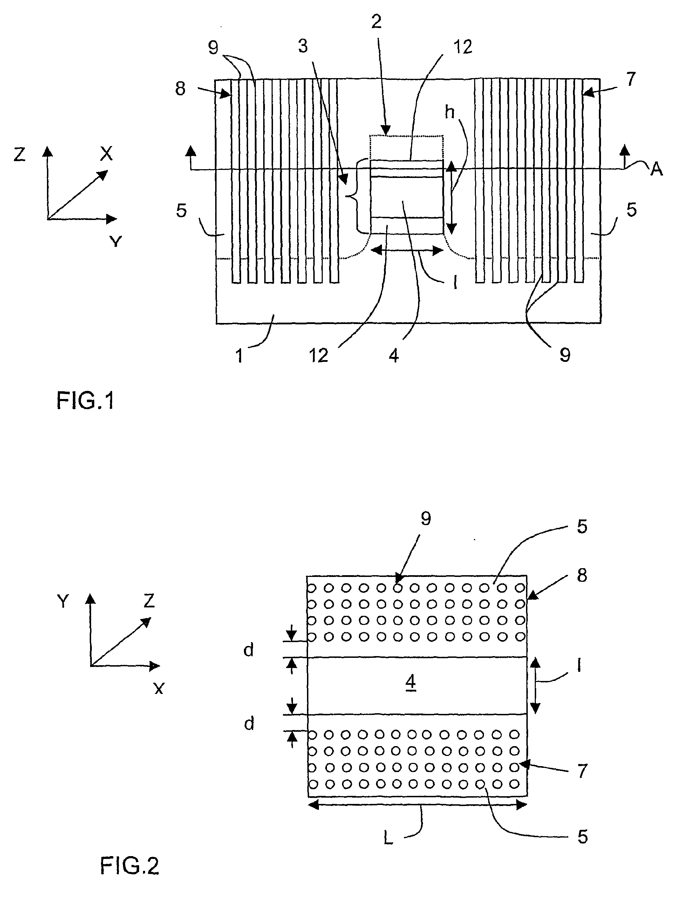

Le repère (X,Y,Z) illustré sur les figures 1 à 4 définit les directions perpendiculaires suivant lesquelles s'étend la structure laser DFB de l'invention. L'axe X définit la direction longitudinale du laser (selon sa longueur L). L'axe Y définit la direction latérale du laser (selon sa largeur I). Et l'axe Z définit la direction verticale d'empilement des couches (par convention, on appelle « partie inférieure » du laser le bas de la figure 1, et « partie supérieure » du laser le haut de la figure 1).

On se réfère tout d'abord aux figures 1 et 2 pour décrire un premier exemple de réalisation d'un laser DFB selon l'invention.

Ce laser DFB comporte tout d'abord un substrat 1 (par exemple de type n), réalisé dans un matériau semiconducteur III-V, tel que par exemple l'InP ou le GaAs. Il comporte également un guide d'onde actif 3, formé par une technique de gravure, situé au dessus du substrat 1 et constitué d'une région active 4, dans laquelle sont produits les photons du mode guidé, et entourée verticalement d'un matériau de confinement optique non dopé 12. Le laser DFB comporte enfin un matériau de rebouchage 5, par exemple en InP dopé p, entourant latéralement et verticalement le guide d'onde actif 3. Sur la figure 1, la frontière 2, entre la région gravée comportant le guide d'onde actif 3 et la région contenant le matériau de rebouchage 5, est matérialisée par des pointillés. Cet exemple de laser DFB est, du fait de son mode de réalisation, du type dit « à ruban enterré ».

Le guide d'onde actif 3 est couplé à un réflecteur distribué réalisé ici sous la forme de deux réseaux diffractants 7, 8 identiques, formés dans les parties latérales du matériau de rebouchage 5, situées de part et d'autre des côtés longitudinaux (ou latéraux) de la région active 4, définis par le plan (X, Z), et sensiblement parallèlement à ces côtés.

Chaque réseau 7, 8 est une structuration particulière du matériau de rebouchage 5, dite « à bande photonique interdite ». Par conséquent, on assimile dans ce qui suit un réseau à sa structuration. Ce type de réseau n-dimensionnel (n étant de préférence égal à 2, mais pouvant également être égal à 1 ou à 3) est bien connu de l'homme de l'art. Il est notamment décrit dans le document de E. Yablanovitch, J. opt. Soc. Am. B 10, 283 (1993), « photonic bandgap structures ». Comme son nom l'indique, il est conçu de manière à posséder une ou plusieurs bandes d'énergie qui sont interdites à certains photons de lumière qui sont émis dans la région active 4. Il permet donc de contrôler (filtrer) la propagation de la lumière, voire même interdire la propagation de certaines de ces longueurs d'onde.

Comme indiqué précédemment, les réseaux 7, 8 servent donc à filtrer certaines longueurs d'onde et non pas à assurer un confinement latéral et vertical, lequel est assuré par la constitution même de la région active 4 et du fait qu'elle est entourée par les matériaux de confinement optique 12 et de rebouchage 5. Mais, ils ont une fonction complémentaire. Leur bande interdite photonique est en effet choisie de manière à assurer un confinement optique « longitudinal » pour la lumière ayant la longueur d'onde de fonctionnement voulue. Cette lumière doit pouvoir pénétrer dans le réseau latéralement, mais elle « voit » la bande interdite photonique dans la direction longitudinale (axe X). En d'autres termes, cette bande d'énergie interdite empêche en quelque sorte la propagation dans le réseau de la lumière suivant la direction longitudinale (axe X) et induit, selon sa relation de phase avec les facettes, des situations de résonance permettant de sélectionner la longueur d'onde du mode guidé. On peut également présenter cette caractéristique comme une inhibition de la propagation longitudinale par couplage entre le réseau et l'onde émise en fonction des conditions de réflexions des facettes.

Préférentiellement, la structuration 7, 8 s'étend sur la totalité de la longueur L de la région active 3. Egalement de préférence, la structuration 7, 8 s'étend sur la quasi totalité de la largeur du matériau de rebouchage 5 qui se trouve placé de part et d'autre de la région active 4. En fait, il est important que la structuration s'étende sur une partie du mode optique. Toujours de préférence, la structuration 7, 8 s'étend sur la totalité de la hauteur du matériau de rebouchage 5 qui se trouve placé de part et d'autre des côtés longitudinaux (ou latéraux) de la région active 4. Comme illustré sur la figure 1, la structuration 7, 8 peut également se prolonger dans une partie au moins du substrat 1.

Dans l'exemple illustré sur la figure 2, la structuration 7, 8 définit un cristal photonique de trous en forme de colonnes 9 qui s'étendent sensiblement suivant la direction verticale (axe Z) et constituent des éléments diffractants qui assurent une variation périodique de la constante diélectrique. De tels trous 9 peuvent être réalisés à l'aide de techniques de gravure localisée telles que la gravure sèche et la gravure par faisceau d'électrons, parfaitement connues de l'homme de l'art. Grâce à ce mode de réalisation du réflecteur distribué, on évite les étapes de reprise de croissance souvent délicates et onéreuses.

En variante, on pourrait réaliser un cristal photonique constitué de colonnes de matériau. Les colonnes sont aussi formées par gravure localisée du matériau de rebouchage, mais de façon à y laisser subsister des colonnes de matériau.

Vu dans un plan horizontal, le réseau du cristal photonique est périodique et présente une maille en forme de polygone convexe. Le nombre de périodes et le pas du réseau suivant l'axe X (lié à la dimension de la maille) et les dimensions des trous (ou colonnes) sont choisis en fonction de la longueur d'onde de fonctionnement recherchée du laser. Ce pas est typiquement de l'ordre de cette longueur d'onde. Par ailleurs, le type du réseau (tout comme le pas) est choisi en fonction de la bande photonique interdite désirée.

Comme illustré, ce type est de préférence carré. Mais il pourrait également s'agir de triangles équilatéraux ou de losanges dont les cotés sont de tailles sensiblement égales.

Le cristal photonique, notamment du fait de son mode de réalisation, offre un avantage important. Il permet en effet de contrôler précisément ce que l'homme de l'art appelle la force du réseau (en anglais « grating strength ») ou coefficient de couplage, qui caractérise l'intensité du couplage entre le réseau et les ondes associées aux photons émis. Grâce au fait que le réseau est situé dans le matériau de rebouchage, en dehors du matéraiu actif, cette force du réseau dépend en effet au premier ordre, principalement, de la distance d qui sépare le bord du réseau 7, 8 du bord longitudinal (ou côté latéral) de la région active 4, et qui est un paramètre important en matière de filtrage de la longueur d'onde des photons. Il en résulte que l'ajustement de la force de couplage peut être obtenu par un simple dimensionnement de la distance d, de façon sensiblement indépendante des autres paramètres de la structure laser.

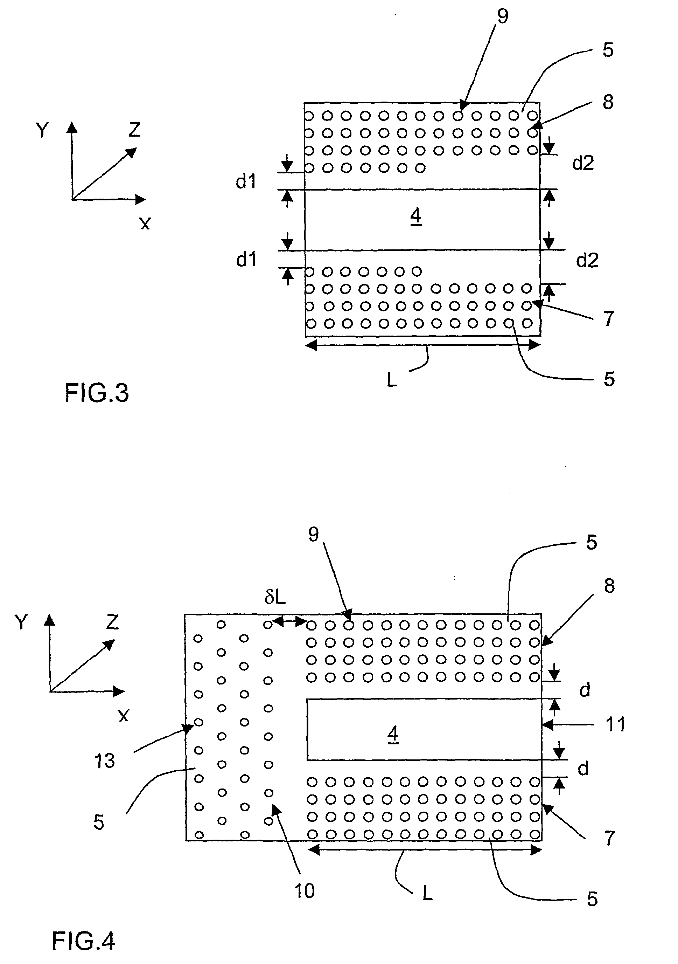

Comme illustré dans l'exemple de réalisation de la figure 2, la distance d peut être constante. Mais, comme illustré dans l'exemple de réalisation de la figure 3, la distance d peut varier le long de l'extension longitudinale L (axe X) de la région active 4. Dans cette variante de la figure 2, le cristal photonique 7, 8 présente une partie « gauche » placée à la distance d1 de la région active 3, et une partie « droite » placée à la distance d2 de cette même région active. Dans cet exemple les parties droite et gauche présentent la même forme de maille (carrée), mais elles pourraient présenter des formes différentes pour offrir simultanément des bandes photoniques interdites différentes et des forces de réseau différentes. D'une façon générale, la loi de variation de cette distance en fonction de la position longitudinale dépend de l'effet recherché et peut être obtenue grâce aux logiciels de simulation dont disposent les équipes de développement des composants optoélectroniques.

Typiquement, on peut ainsi optimiser la sélectivité spectrale du laser. Ce mode de réalisation permet par exemple de compenser spatialement ce que l'homme de l'art appelle en anglais le « hole burning », qui résulte d'interférences survenant dans le réseau du fait de la propagation du champ selon des directions opposées. En effet, lorsque la structure laser est sensiblement uniforme, la distribution de la densité de puissance présente généralement des creux et des ventres. A forte puissance de fonctionnement du laser, la densité de porteurs dans la région active se trouve donc saturée au niveau des ventres, et cette répartition inhomogène le long de la structure dégrade la sélectivité spectrale. Grâce à l'invention, il est désormais possible de contrôler facilement la distribution de la densité de puissance dans la structure laser.

On peut également envisager une autre variante dans laquelle la distance d est constante le long de la région active 4, mais avec un réseau diffractant constitué de deux cristaux photoniques, voire plus, présentant des mailles différentes pour offrir des bandes photoniques interdites différentes localement.

La distance d ou les distances di (i=1, 2 sur la figure 3) sont préférentiellement contrôlées par masquage lors de l'étape de lithographie, typiquement à l'échelle du nanomètre.

On se réfère maintenant à la figure 4 pour décrire un autre exemple de réalisation de laser DFB selon l'invention.

Il s'agit d'une variante du laser illustré sur les figures 1 à 3, dans laquelle l'extrémité longitudinale arrière (ou gauche) de la région active 4 est également entourée de matériau de rebouchage 5 dans lequel est formé un miroir réfléchissant arrière 10 réalisé sous la forme d'une structuration à bande photonique interdite tandis que l'extrémité longitudinale avant, opposée, est une face miroir classique 11 du composant munie d'un revêtement anti-réfléchissant. Dans une variante, chaque face d'extrémité longitudinale pourrait être équipée d'une structuration à bande photonique interdite.

Ce mode de réalisation est destiné à réduire, voire supprimer, les variations de comportement spectral et/ou de seuil et/ou de rendement et/ou d'autres paramètres qui surviennent entre lasers DFB de même type en raison des variations de l'ordre de la fraction de longueur d'onde des positions des facettes relativement aux réflecteurs distribués.

La structuration du miroir arrière 10 est similaire à celle des réflecteurs distribués 7, 8 présentés en référence aux figures 1 et 2. Elle peut par conséquent être réalisée lors de la même étape. Elle s'étend dans le matériau de rebouchage sensiblement perpendiculairement au plan (X, Y), et donc sensiblement suivant la direction verticale Z.

Cette structuration 10 (que l'on assimile ci-après au miroir arrière) s'étend sur une partie au moins de la largeur I du guide d'onde 3, et au moins sur toute la largeur de la région active 4 et la zone d'extension latérale de la première structuration 7, 8. Par ailleurs, cette structuration s'étend au moins sur la hauteur de la région active 4, mais de préférence sur toute la hauteur h du guide d'onde 3.

Par ailleurs, comme dans la première structuration, cette seconde structuration 10 définit sensiblement un second cristal photonique de trous 13 qui s'étendent sensiblement suivant la direction verticale (axe Z) et constituent des éléments diffractants qui assurent une variation périodique de la constante diélectrique. En variante, on pourrait réaliser un cristal photonique de colonnes à la place du cristal photonique de trous.

Comme le premier cristal photonique, ce second cristal photonique est préférentiellement un réseau périodique et présentant une maille en forme de polygone convexe. De même, le nombre de périodes et le pas du réseau suivant l'axe X (lié à la dimension de la maille) et les dimensions des trous (ou colonnes) sont choisis en fonction de la longueur d'onde de fonctionnement recherchée du laser. Ce pas est typiquement de l'ordre de cette longueur d'onde. Par ailleurs, le type du réseau (tout comme le pas) est choisi en fonction de la bande photonique interdite désirée.

Comme illustré sur la figure 4, ce type est de préférence à maille triangulaire équilatéral. Mais, il pourrait également s'agir de carrés (éventuellement identiques à ceux du premier cristal photonique) ou de losanges dont les côtés sont de tailles sensiblement égales. En effet, le réseau latéral 7, 8 doit présenter une bande interdite selon l'axe longitudinal, mais préférentiellement pas selon l'axe latéral, tandis que le réseau 10 en extrémité de laser peut préférentiellement présenter une bande interdite selon ces deux directions (latérales et longitudinale).

Les polygones convexes des premier et second cristaux photoniques sont de préférence dimensionnés de façon à présenter des longueurs d'onde de Bragg sensiblement identiques.

La seconde structuration 10 est formée à une distance δL de l'extrémité longitudinale arrière de la première structuration 7, 8. Ce mode de réalisation de réflecteur au moyen du second cristal photonique permet de contrôler précisément, typiquement à l'échelle du nanomètre, la distance δL qui contribue de façon importante aux propriétés du laser DFB, et notamment à son taux de réjection des modes secondaires ("SMSR"), son seuil et son rendement.

Par ailleurs, cette distance δL peut être choisie sensiblement égale à un nombre entier de fois la demie longueur d'onde des photons dans le mode guidé (c'est-à-dire la demie longueur d'onde de fonctionnement dans le matériau), de sorte que les première et seconde structurations définissent une cavité résonnante de type Fabry-Pérot accordée sur la longueur d'onde de fonctionnement du laser.

Un laser DBF équipé d'un réflecteur distribué à distance di variable, du type de celui illustré sur la figure 3, peut être également équipé d'un miroir arrière et/ou d'un miroir avant à bande photonique interdite, du type de celui illustré sur la figure 4.

Des dimensions typiques des éléments d'une structure du type de celle illustrée sur la figure 4 sont données ci-après, à titre d'exemple non limitatif.

Pour réaliser par exemple sur une même plaque un ensemble de puces laser couvrant des longueurs d'onde de la bande C, on peut former un miroir d'extrémité large bande comportant une vingtaine de rangées de cristaux triangulaires équilatéraux et présentant un coefficient de remplissage d'air d'environ 0,3 et une période (distance entre barycentres des triangles) de l'ordre de 340 nm, pour une lumière incidente selon une direction parallèle à la médiatrice des triangles. La période peut présenter des variations d'environ 10 nm, étant donné que l'on attend des réflexions large bande sur environ 100 nm.

Le réflecteur latéral, à coefficient de remplissage d'air d'environ 0,3, peut être réalisé à l'aide d'un simple réseau unidimensionnel (1D), avec une modulation suivant l'axe X et une longueur d'onde de Bragg adaptée à la longueur d'onde d'émission du laser. Pour obtenir une longueur d'onde d'émission d'environ 1550 nm, avec un dispositif présentant un indice effectif d'environ 3,2, la période doit être d'environ 242,2 nm. L'extension latérale du cristal doit être au moins égale à celle du mode transverse, soit typiquement 10 µm de chaque côté.

La distance de séparation entre les bords longitudinaux (ou latéraux) de la région active 4 et les réflecteurs latéraux placés de part et d'autre de ces bords est en moyenne de l'ordre du micromètre. Mais, elle peut varier localement de 0 à 10 µm afin de couvrir une large plage de forces de réseau. Par ailleurs, pour une tolérance d'environ 10 nm sur la longueur d'onde d'émission du laser, il est nécessaire de contrôler la période à ± 0,8 nm environ.

La distance optique entre les réflecteurs latéraux et le réflecteur d'extrémité peut être égale à environ 242,2 nm de manière à être de l'ordre de la demie longueur d'onde de fonctionnement du laser dans le matériau de rebouchage. Par ailleurs, la même tolérance que celle acceptée pour les réflecteurs latéraux peut être envisagée pour cette distance optique.

Une telle structure permet de fonctionner avec une longueur d'onde d'environ 1550 nm dans l'air.

L'invention ne se limite pas aux modes de réalisation décrits ci-avant, seulement à titre d'exemple, mais elle englobe toutes les variantes que pourra envisager l'homme de l'art dans le cadre des revendications ci-après.

## Revendications

1. Laser semi-conducteur, comprenant un guide d'onde actif (3) s'étendant selon des directions longitudinale (X), latérale (Y) et verticale (Z), comportant une région active (4), entouré d'un matériau de rebouchage (5) et couplé à un réflecteur distribué (7,8), **caractérisé en ce que** ledit réflecteur distribué (7,8) est réalisé dans ledit matériau de rebouchage (5) le long d'au moins un des côtés latéraux de la région active (4) et sensiblement parallèlement à ceux-ci, sous la forme d'au moins une première structuration (7,8) présentant une bande photonique interdite selon ledit axe longitudinal (X).

2. Laser selon la revendication 1, **caractérisé en ce que** ladite première structuration (7,8) s'étend sur une partie au moins de l'extension (h) de la région active (4) suivant la direction verticale (Z), et sur une partie au moins de l'extension (h) du matériau de rebouchage (5) suivant la direction verticale (Z).

3. Laser selon l'une des revendications 1 ou 2, **caractérisé en ce que** ladite première structuration (7,8) est un premier cristal photonique formé par gravure localisée du matériau de rebouchage (5) de façon à y former des colonnes (9) creuses ou à y laisser subsister des colonnes de matériau, ces colonnes constituant un réseau périodique d'éléments diffractants présentant dans un plan horizontal une maille ayant des dimensions de l'ordre de la longueur d'onde de fonctionnement du laser.

4. Laser selon la revendication 3, **caractérisé en ce que** lesdites colonnes (9) s'étendent sensiblement parallèlement à ladite direction verticale (Z) de la région active (4).

5. Laser selon l'une des revendications 3 ou 4, **caractérisé en ce que** ladite maille de réseau du premier cristal photonique a une forme de polygone convexe.

6. Laser selon la revendication 5, **caractérisé en ce que** ledit polygone est un polygone régulier.

7. Laser selon l'une des revendications 1 à 6, **caractérisé en ce que** ladite première structuration (7,8) est espacée des côtés latéraux de la région active d'une distance (d) sensiblement constante.

8. Laser selon l'une des revendications 1 à 6, **caractérisé en ce que** ladite première structuration (7,8) est espacée des côtés latéraux de la région active d'une distance (d1 , d2) qui varie le long de l'extension (L) de ladite région active (4) suivant la direction longitudinale (X).

9. Laser selon l'une des revendications 1 à 8, **caractérisé en ce que** ledit guide d'onde actif comporte, à l'une au moins des extrémités longitudinales de la région active (4), un matériau de rebouchage (5) dans lequel sont formés, à une distance δL de la première structuration (7,8), des moyens de réflexion (10) réalisés sous la forme d'une seconde structuration à bande photonique interdite et s'étendant sensiblement parallèlement à l'extension (I) de la région active (4) suivant la direction latérale (Y).

10. Laser selon la revendication 9, **caractérisé en ce que** ladite seconde structuration (10) s'étend au moins sur toute l'extension (h) de la région active (4) suivant la direction verticale (Z).

11. Laser selon l'une des revendications 9 ou 10, **caractérisé en ce que** ladite seconde structuration (10) s'étend sur toute l'extension (I) de la région active (4) suivant la direction latérale (Y) et sur une partie au moins de l'extension du matériau de rebouchage (5) suivant la direction latérale (Y).

12. Laser selon l'une des revendications 9 à 11, **caractérisé en ce que** ladite seconde structuration (10) est un second cristal photonique formé par gravure localisée du matériau de rebouchage (5) de façon à y former des colonnes (13) creuses ou à y laisser subsister des colonnes de matériau, ces colonnes constituant un réseau périodique d'éléments diffractants présentant dans un plan horizontal une maille ayant des dimensions de l'ordre de la longueur d'onde de fonctionnement du laser.

13. Laser selon la revendication 12, **caractérisé en ce que** lesdites colonnes (13) s'étendent sensiblement parallèlement à ladite direction verticale (Z) de la région active (4).

14. Laser selon l'une des revendications 12 ou 13, **caractérisé en ce que** ladite maille de réseau du second cristal photonique a une forme de polygone convexe.

15. Laser selon la revendication 14, **caractérisé en ce que** ledit polygone est un polygone régulier.

16. Laser selon l'une des revendications 9 à 15, **caractérisé en ce que** ladite distance δL est sensiblement égale à un nombre entier de fois la demie longueur d'onde de fonctionnement du laser dans le matériau de rebouchage, de sorte que les première et seconde structurations (7,8 ;10) définissent une cavité résonnante de type Fabry-Pérot.

## Claims

1. A semi-conductor laser, comprising an active waveguide (3) extending in the longitudinal (X), lateral (Y), and vertical (Z) directions, comprising an active region (4), surrounded by a filling material (5) and coupled to a distributed reflector (7, 8), **characterized in that** said distributed reflector (7, 8) is made of said filling material (5) along at least one of the lateral sides of the active region (4) and substantially in parallel thereto, in the form of at least one first structuring (7, 8) having a photonic band gap along said longitudinal axis (X).

2. The laser according to claim 1, **characterized in that** said first structuring (7, 8) extends on one part at least of the extension (h) of the active region (4) in the vertical direction (Z), and on one part at least of the extension (h) of the filling material (5) in the vertical direction (Z).

3. The laser according to any of claims 1 or 2, **characterized in that** said first structuring (7, 8) is a first photonic crystal formed by localized etching of the filling material (5) so as to form hollow columns (9) therein or leave material columns therein, such columns composing a periodic grid of diffracting elements having in a horizontal plane a mesh having dimensions on the order of the laser's operating wavelength.

4. The laser according to claim 3, **characterized in that** said columns (9) extend substantially in parallel to said vertical direction (Z) of the active region (4).

5. The laser according to any of claims 3 or 4, **characterized in that** said grid mesh of the first photonic crystal has the shape of a convex polygon.

6. The laser according to claim 5, **characterized in that** said polygon is a regular polygon.

7. The laser according to any of claims 1 to 6, **characterized in that** said first structuring (7, 8) is spaced apart from the lateral sides of the active region by a substantially constant distance (d).

8. The laser according to any of claims 1 to 6, **characterized in that** said first structuring (7, 8) is spaced apart from the lateral sides of the active region by a distance (d1, d2) varying along the extension (L) of said active region (4) in the longitudinal direction (X).

9. The laser according to any of claims 1 to 8, **characterized in that** said active waveguide comprises, at least at one of the longitudinal ends of the active region (4), a filling material (5) in which are formed, at a distance δL from the first structuring (7, 8), reflective means (10) made in the form of a second structuring having a photonic band gap and extending substantially in parallel to the extension (I) of the active region (4) in the lateral direction (Y).

10. The laser according to claim 9, **characterized in that** said second structuring (10) extends at least on the entire extension (h) of the active region (4) in the vertical direction (Z).

11. The laser according to any of claims 9 or 10, **characterized in that** said second structuring (10) extends over the entire extension (I) of the active region (4) in the lateral direction (Y) and on one part at least of the extension of the filling material (5) in the lateral direction (Y).

12. The laser according to any of claims 9 to 11, **characterized in that** said second structuring (10) is a second photonic crystal formed by localized etching of the filling material (5) so as to form hollow columns (13) therein or leave material columns therein, such columns composing a periodic grid of diffracting elements having in a horizontal plane a mesh having dimensions on the order of the laser's operating wavelength.

13. The laser according to claim 12, **characterized in that** said columns (13) extend substantially in parallel to said vertical direction (Z) of the active region (4).

14. The laser according to any of claims 12 or 13, **characterized in that** said grid mesh of the second photonic crystal has the shape of a convex polygon.

15. The laser according to claim 14, **characterized in that** said polygon is a regular polygon.

16. The laser according to any of claims 9 to 15, **characterized in that** said distance δL is substantially equal to an integer times half the operating wavelength of the laser in the filling material, so that the first and second structuring (7, 8; 10) define a Fabry-Pérot type resonator cavity.

## Patentansprüche

1. Halbleiterlaser, umfassend einen aktiven Wellenleiter (3), der sich in den längsgerichteten (X), seitlichen (Y) und senkrechten (Z) Richtungen erstreckt, umfassend einen aktiven Bereich (4), der von einem Füllmaterial (5) umgeben ist und mit einem verteilten Reflektor (7, 8) gekoppelt ist, **dadurch gekennzeichnet, dass** der verteilte Reflektor (7, 8) aus dem Füllmaterial (5) an mindestens einer der seitlichen Seiten des aktiven Bereichs (4) entlang und im Wesentlichen parallel dazu, in Form mindestens einer ersten Strukturierung (7, 8), die eine photonische Bandlücke an der Längsachse (X) entlang aufweist, ausgebildet ist.

2. Laser nach Anspruch 1, **dadurch gekennzeichnet, dass** die erste Strukturierung (7, 8) sich mindestens auf einem Teil der Ausdehnung (h) des aktiven Bereichs (4) in der senkrechten Richtung (Z) und mindestens auf einem Teil der Ausdehnung (h) des Füllmaterials (5) in der senkrechten Richtung (Z) erstreckt.

3. Laser nach einem der Ansprüche 1 oder 2, **dadurch gekennzeichnet, dass** die erste Strukturierung (7, 8) ein erster photonischer Kristall ist, der durch örtlich begrenztes Ätzen des Füllmaterials (5) gebildet wird, um darin hohle Kolonnen (9) zu bilden oder darin Materialkolonnen übrigzulassen, wobei diese Kolonnen ein periodisches Gitter aus Beugungselementen bilden, das in einer waagerechten Ebene eine Zelle mit Dimensionen in der Größenordnung der Betriebswellenlänge des Lasers aufweist.

4. Laser nach Anspruch 3, **dadurch gekennzeichnet, dass** die Kolonnen (9) sich im Wesentlichen parallel zur senkrechten Richtung (Z) des aktiven Bereichs (4) erstrecken.

5. Laser nach einem der Ansprüche 3 oder 4, **dadurch gekennzeichnet, dass** die Gitterzelle des ersten photonischen Kristalls die Form eines konvexen Vielecks aufweist.

6. Laser nach Anspruch 5, **dadurch gekennzeichnet, dass** das Vieleck ein regelmäßiges Vieleck ist.

7. Laser nach einem der Ansprüche 1 bis 6, **dadurch gekennzeichnet, dass** die erste Strukturierung (7, 8) von den seitlichen Seiten des aktiven Bereichs um einen im Wesentlichen konstanten Abstand (d) beabstandet ist.

8. Laser nach einem der Ansprüche 1 bis 6, **dadurch gekennzeichnet, dass** die erste Strukturierung (7, 8) von den seitlichen Seiten des aktiven Bereichs um einen Abstand (d1, d2) beabstandet ist, der sich an der Ausdehnung (L) des aktiven Bereichs (4) entlang in der Längsrichtung (X) ändert.

9. Laser nach einem der Ansprüche 1 bis 8, **dadurch gekennzeichnet, dass** der aktive Wellenleiter mindestens an einem der Längsenden des aktiven Bereichs (4) ein Füllmaterial (5) umfasst, in dem in einem Abstand δL von der ersten Strukturierung (7, 8) Reflexionsmittel (10) angeordnet sind, die in Form einer zweiten Strukturierung, die eine photonische Bandlücke aufweist, ausgebildet sind und sich im Wesentlichen parallel zur Ausdehnung (I) des aktiven Bereichs (4) in der seitlichen Richtung (Y) erstrecken.

10. Laser nach Anspruch 9, **dadurch gekennzeichnet, dass** die zweite Strukturierung (10) sich mindestens über die ganze Ausdehnung (h) des aktiven Bereichs (4) in der senkrechten Richtung (Z) erstreckt.

11. Laser nach einem der Ansprüche 9 oder 10, **dadurch gekennzeichnet, dass** sich die zweite Strukturierung (10) über die ganze Ausdehnung (I) des aktiven Bereichs (4) in der seitlichen Richtung (Y) und mindestens auf einem Teil der Ausdehnung des Füllmaterials (5) in der seitlichen Richtung (Y) erstreckt.

12. Laser nach einem der Ansprüche 9 bis 11, **dadurch gekennzeichnet, dass** die zweite Strukturierung (10) ein zweiter photonischer Kristall ist, der durch örtlich begrenztes Ätzen des Füllmaterials (5) gebildet wird, um darin hohle Kolonnen (13) zu bilden oder darin Materialkolonnen übrigzulassen, wobei diese Kolonnen ein periodisches Gitter aus Beugungselementen bilden, das in einer waagerechten Ebene eine Zelle mit Dimensionen in der Größenordnung der Betriebswellenlänge des Lasers aufweist.

13. Laser nach Anspruch 12, **dadurch gekennzeichnet, dass** die Kolonnen (13) sich im Wesentlichen parallel zur senkrechten Richtung (Z) des aktiven Bereichs (4) erstrecken.

14. Laser nach einem der Ansprüche 12 oder 13, **dadurch gekennzeichnet, dass** die Gitterzelle des zweiten photonischen Kristalls die Form eines konvexen Vielecks aufweist.

15. Laser nach Anspruch 14, **dadurch gekennzeichnet, dass** das Vieleck ein regelmäßiges Vieleck ist.

16. Laser nach einem der Ansprüche 9 bis 15, **dadurch gekennzeichnet, dass** der Abstand δL im Wesentlichen gleich einem ganzzahligen Vielfachen der halben Betriebswellenlänge des Lasers in dem Füllmaterial ist, so dass die ersten und zweiten Strukturierungen (7, 8; 10) einen Resonanzraum nach Fabry-Pérot bilden.
